# FASCICULE DE BREVET EUROPEEN

(11) **EP 3 567 527 B1**
(45) Date de publication et mention de la délivrance du brevet: **13.10.2021**
(21) Numéro de dépôt: 19183469.6
(22) Date de dépôt: 13.05.2015
(51) Int. Cl.: G06K 19/077

(54) **PROCÉDÉ DE FABRICATION D'UN CIRCUIT POUR MODULE DE CARTE À PUCE ET CIRCUIT POUR MODULE DE CARTE À PUCE**
HERSTELLUNGSVERFAHREN EINES SCHALTKREISES FÜR CHIPKARTENMODUL, UND SCHALTKREIS FÜR CHIPKARTENMODUL
METHOD OF MANUFACTURING A CIRCUIT FOR CHIP-CARD MODULE AND CIRCUIT FOR CHIP-CARD MODULE

(30) Priorité: 14.05.2014 FR 1454287
(43) Date de publication de la demande: 13.11.2019
(62) Demande divisionnaire de: 15750796.3
(73) Titulaire: Linxens Holding, 78200 Mantes-la-Jolie (FR)
(72) Inventeur: MATHIEU, Christophe, 78200 MANTES LA JOLIE (FR); HOVEMAN, Bertrand, 95610 ERAGNY-SUR-OISE (FR)
(74) Mandataire: INNOV-GROUP

(56) Documents cités:
- EP-A1- 1 816 593
- EP-A1- 1 887 494
- EP-A1- 2 579 187
- US-A1- 2013 062 419

## Description

L'invention concerne le domaine des cartes à puces. Les cartes à puce sont bien connues du public, qui en a de multiples usages : cartes de paiement, cartes SIM pour téléphones portables, cartes de transport, cartes d'identité, etc.

Les cartes à puce comportent des moyens de transmission pour transmettre des données de la puce à un dispositif lecteur de carte (lecture) ou de ce dispositif à la carte (écriture). Ces moyens de transmission peuvent être « à contact », « sans contact » ou bien à double-interface lorsqu'ils combinent les deux précédents moyens. L'invention concerne en particulier le domaine des cartes à puce à double interface. Les cartes à puce à double interface sont appelées « dual » si les modes « avec contact » et « sans contact » sont gérés par une seule puce ou « hybrides » si les modes « avec contact » et « sans contact » sont gérés par deux puces physiquement distinctes.

Les cartes à puce à double interface sont généralement constituées d'un support rigide en matière plastique de type PVC, PVC/ABS, PET ou polycarbonate constituant l'essentiel de la carte, dans lequel sont incorporés un module électronique et une antenne fabriqués séparément. Le module électronique comporte un circuit imprimé généralement flexible muni d'une puce électronique (circuit intégré) et des plages de contacts électriquement connectées à la puce et affleurant sur le module électronique, en surface du support, pour une connexion par contact électrique avec un dispositif lecteur de carte. Les cartes à puce à double interface comportent en outre au moins une antenne pour transmettre des données entre la puce et un système radiofréquence permettant la lecture/écriture sans contact de données.

Dans l'art antérieur, il a souvent été proposé de connecter l'antenne sur des plages conductrices réalisées sur la face opposée à celle comportant les contacts. Autrement dit, le module électronique à insérer dans une carte est un circuit dit « double-face », avec une face conductrice avec les contacts et une face conductrice avec les plages conductrices de l'antenne, ces deux faces conductrices étant disposées chacune respectivement sur une face d'un substrat isolant. Alternativement, comme décrit dans le document US5598032, des plages conductrices situées sur la même face que les contacts peuvent être pour la connexion de l'antenne.

Un but de l'invention est de concevoir des modules pour cartes « dual » plus économiques à fabriquer.

A cette fin, il est prévu un procédé de fabrication d'un circuit flexible pour module de carte à puce dans lequel on fournit un substrat isolant et une seule couche conductrice supportée par ce substrat isolant. Dans cette couche conductrice sont réalisés les contacts. La réalisation des contacts peut se faire par gravure d'une feuille de matériau électriquement conducteur tel qu'un alliage de cuivre, préalablement collée et/ou laminée sur le substrat isolant, avec ou sans couche de colle entre le substrat isolant et la couche conductrice. Alternativement, la réalisation des contacts peut se faire par découpe (technique dite du « leadframe » selon la terminologie anglo-saxonne) des contacts dans une feuille de matériau électriquement conducteur tel qu'un alliage de cuivre, préalablement à son collage et/ou sa lamination sur le substrat isolant (également avec ou sans couche de colle entre le substrat isolant et la couche conductrice).

Selon ce procédé, le substrat isolant est perforé pour former des puits de connexion. Dans le cas où les contacts sont gravés dans la couche de conductrice après que celle-ci soit reportée sur l'une des faces du substrat, cette étape de perforation est avantageusement réalisée par poinçonnage (« punching » selon la terminologie anglo-saxonne) du substrat isolant avant que celui-ci ne reçoive la couche conductrice.

Dans tous les cas, la couche conductrice est donc finalement supportée par le substrat isolant, avec une première face tournée vers le substrat isolant et une deuxième face destinée à établir une connexion par contact électrique avec un lecteur de cartes à puce.

En outre, la couche conductrice recouvre au moins partiellement des puits de connexion, la première face de celle-ci étant destinée à établir, au niveau de puits de connexion, une connexion électrique avec une puce électronique. Généralement, la couche conductrice recouvre totalement les puits de connexion pour former des trous borgnes. Mais il peut arriver en particulier qu'un micro-trou soit réalisé dans la couche conductrice au niveau de la zone recouvrant un puits de connexion.

On réalise aussi dans la couche conductrice au moins deux plages conductrices, électriquement isolées des contacts, au niveau desquelles la première face de la couche conductrice obture au moins partiellement au moins un puits de connexion destiné à la connexion d'une puce électronique avec une antenne.

Le circuit flexible pour module de carte à puce ainsi réalisé ne comporte donc qu'une face conductrice et permet d'économiser une couche de matériau conducteur sur l'autre face du substrat isolant. Néanmoins, grâce aux plages conductrices, distinctes et électriquement isolées des contacts destinés à la connexion avec un lecteur de cartes, il est possible de connecter une puce à travers les puits de connexion à une antenne.

Par exemple, on réalise cinq contacts dans la couche conductrice, chacun respectivement pour la connexion de la masse, de l'alimentation, de l'entrée/sortie, de l'horloge et la remise à zéro d'une puce électronique, ainsi que deux plages conductrices supplémentaires. Les deux plages conductrices supplémentaires servant alors chacune respectivement à la connexion d'une extrémité (ou borne) d'une antenne.

Le procédé selon l'invention est particulièrement avantageux lorsque l'on souhaite miniaturiser les modules et/ou ses plages conductrices, et notamment lorsqu'on peut réduire le nombre de contacts reliés à la puce. Grâce au procédé selon l'invention, on peut optimiser les dimensions et l'orientation des différentes plages conductrices et des contacts dans un module de carte à puce. Ainsi, par exemple, deux plages conductrices sont réalisées chacune respectivement essentiellement de part et d'autre d'une zone centrale destinée à recevoir la puce électronique. Comme les contacts peuvent, dans certains cas, être agencés et répartis sur deux rangées situées chacune respectivement de part et d'autre d'une zone centrale destinée à recevoir la puce électronique, il peut rester deux zones entre ces deux rangées, pour former sur chacune d'elle, une plage conductrice. On a alors les deux plages conductrices, chacune respectivement essentiellement située de part et d'autre de la zone centrale destinée à recevoir la puce électronique, avec les deux plages conductrices et la zone centrale destinée à recevoir la puce électronique réparties sur une rangée située entre les rangées de contacts. Cette disposition est particulièrement avantageuse, puisque dans une carte à puce rectangulaire, le module peut être orienté pour que les deux rangées de contacts, chacune respectivement disposée essentiellement de part et d'autre de la puce, soient perpendiculaires à la plus grande dimension de la carte. Chacune des extrémités de l'antenne peut alors venir au niveau d'un bord du module et de sa cavité, essentiellement perpendiculaire au plus petit côté de la carte. Comme, il faut néanmoins laisser un espace entre ces extrémités pour la puce et sa résine d'encapsulation, on réalise un puits de connexion destiné à la connexion de la puce électronique avec l'antenne, au niveau de chacune des deux plages conductrices, de manière à ce que la distance entre les puits soit supérieure à la dimension de la cavité ménagée dans la carte pour recevoir la puce électronique et sa résine d'encapsulation.

Il existe plusieurs manières de procéder à la connexion de la puce à l'antenne. On peut réaliser pour chaque plage conductrice au moins deux puits de connexion, c'est-à-dire deux puits de connexion séparés par une portion du substrat isolant. Sur chaque plage conductrice, l'un des puits de connexion est utilisé pour une connexion électrique avec la puce électronique, et l'autre pour une connexion électrique avec l'antenne. Selon l'invention, on réalise un puits unique, de dimension suffisante dans un plan parallèle aux première et deuxième faces de la couche conductrice (il est par exemple oblong), afin de connecter électriquement la puce électronique et l'antenne en deux emplacements sur la même plage conductrice. Avantageusement, on réalise la connexion (à travers un puits dédié uniquement ou non à cette connexion) avec la puce électronique dans une zone d'encapsulation correspondant à une zone destinée à être recouverte par un matériau de protection de la puce et de ses connexions aux contacts et aux plages conductrices. En effet, dans le module de carte à puce fini, la puce est placée sur la face du substrat opposée à celle sur laquelle se trouve la couche conductrice ou dans une découpe réalisée dans celui-ci, et la puce et ses connexions sont encapsulés dans une résine (« globe top » ou « dam&fill » selon la terminologie anglo-saxonne, correspondant à une encapsulation UV ou thermique). La connexion de chaque plage conductrice avec l'antenne peut être réalisée après cette étape d'encapsulation. Elle s'effectue alors hors de la zone d'encapsulation à travers un puits dédié uniquement ou non à cette connexion.

Des étapes du procédé selon l'invention peuvent être réalisées chez un même fabricant ou chez des industriels différents. Par exemple, la puce électronique peut être attachée à un circuit pour module de carte à puce comprenant le substrat isolant et la couche conductrice, puis connectée à travers les puits de connexion, à la fois aux contacts et aux plages conductrices, chez un industriel différent de celui qui a fabriqué le circuit pour module de carte à puce (sans la puce et ses connexion). La connexion d'une antenne avec un circuit pour module de carte à puce supportant une puce (éventuellement déjà encapsulée dans une résine protectrice) peut se faire éventuellement encore chez un autre industriel. Mais on comprendra que dans tous les cas, il est essentiel que le circuit (dit « simple face ») pour module de carte à puce soit adapté pour une connexion de la puce à l'antenne via la couche conductrice située sur la face dite « face avant » ou « face contact » du module. Pour cela, comme indiqué ci-dessus, il doit comporter au moins deux plages conductrices, électriquement isolées des contacts, au niveau desquelles la première face de la couche conductrice obture au moins partiellement au moins un puits de connexion destiné à la connexion d'une puce électronique avec une antenne.

Afin de faciliter les opérations d'intégration du module dans une carte à puce, on peut prévoir que le substrat isolant soit essentiellement constitué d'un matériau adhésif non-réactivable thermiquement. On considère que le matériau est adhésif par le fait qu'il adhère sur le support sur lequel il est appliqué (par enduction s'il est sous forme liquide ou par lamination s'il est sous forme de film). On peut aussi prévoir que le substrat isolant soit essentiellement constitué d'un matériau adhésif réactivable thermiquement (« hot-melt » selon la terminologie anglo-saxonne). Dans ce cas, il est également adhésif par le fait que même après enduction et séchage, ses propriétés adhésives peuvent être réactivées par chauffage. La température de transition vitreuse Tg du matériau adhésif non-réactivable thermiquement est préférentiellement inférieure à 100°C. Il a par exemple une température de transition vitreuse Tg de l'ordre de 50°C (ou plus généralement entre 40°C et 60°C). Le matériau adhésif est par exemple un époxy modifié par un thermoplastique (de type polyamide par exemple).

Si le matériau adhésif doit être enduit, sa viscosité est adaptée pour qu'il puisse être étalé à température ambiante sur la couche électriquement conductrice ou un substrat intermédiaire amovible. Par exemple sa viscosité en phase solvant est de l'ordre de 80 mPa.s (plus généralement comprise entre 60 et 100 mPa.s).

La connexion de l'antenne aux plages conductrices, à travers les puits de connexion, peut se faire de plusieurs manières : à l'aide d'une encre ou d'une pâte conductrice remplissant les puits de connexion et formant éventuellement une surépaisseur (« bumps » selon la terminologie anglo-saxonne) au-dessus des puits de connexion par rapport à la surface de la face du substrat opposée à la face contact, à l'aide d'une encre ou d'une pâte conductrice formant une surépaisseur sur les extrémités de l'antenne pour venir établir une connexion au fond des puits de connexion, à l'aide de fils conducteurs (or) traversant les puits de connexion, etc. On peut également utiliser un substrat (éventuellement adhésif) avec des propriétés électriques anisotropes : électriquement isolant dans un plan et conducteur perpendiculairement à ce plan.

Dans certains cas, notamment lorsqu'il est nécessaire de renforcer la fixation et/ou la connexion des extrémités de l'antenne aux plages conductrices, on réalise plus de deux puits de connexion au niveau d'au moins une plage conductrice. Par exemple, les puits de connexion peuvent former un réseau plus ou moins régulier de trous (quadrillage, trous disposés sur des cercles concentriques, en rosace, etc.). La pâte, la colle ou l'encre conductrice vient alors établir un ancrage mécanique et une liaison électrique avec les plages conductrices tout en emprisonnant les portions de substrat laissées entre les trous.

Ces multiples puits de connexion permettent également de mieux maitriser la diffusion et la répartition de la matière conductrice (pâte, encre ou colle) plus ou moins liquide.

Selon un autre aspect, l'invention concerne un circuit flexible pour la mise en oeuvre d'un procédé de fabrication d'un module de carte à puce (ou de fabrication d'une carte à puce complète) dans lequel on utilise des plages conductrices situées sur la même face du module que les contacts destinés à établir une connexion avec un lecteur de carte, pour réaliser une connexion électrique entre une antenne et une puce électronique.

Ainsi, ce circuit flexible comporte un substrat isolant dont l'épaisseur, la souplesse et la flexibilité sont compatibles avec, d'une part, sa mise en oeuvre dans un procédé de fabrication de bobine à bobine en continu (« reel-to-reel» selon la terminologie anglo-saxonne) et, d'autre part, avec les normes et standards déterminant l'épaisseur maximale des cartes à puce finies. Ce substrat se présente sous forme d'une feuille ayant une première et une deuxième faces principales essentiellement parallèles entre elles. Ce substrat diélectrique est généralement mince. Son épaisseur, avantageusement inférieure à 400µm, est par exemple de l'ordre de 20 à 200µm, voire comprise entre 50 et 150µm. Ce substrat est par exemple un film souple de matériau plastique (polyimide, PET, PEN, PVC, etc.) ou de matériau composite (verre-époxy). Il peut également être constitué d'une simple et unique couche d'adhésif dont les propriétés adhésives sont éventuellement réactivables thermiquement (à une température comprise entre 130°C et 200°C). Ce matériau isolant, éventuellement adhésif, peut aussi avoir des propriétés conductrices anisotropes.

Le substrat isolant comporte des puits de connexion traversant la totalité de son épaisseur afin de pouvoir établir une connexion entre une puce située sur la face dite « arrière » (ou « bonding side » selon la terminologie anglo-saxonne) et des contacts et des plages conductrices, électriquement isolées des contacts, situés sur la face dite « avant » (ou « contact side » selon la terminologie anglo-saxonne).

Le substrat isolant comporte donc une couche conductrice supportée par le substrat isolant, avec une première face tournée vers le substrat isolant et une deuxième face. Les contacts et plages conductrices sont formés dans cette couche conductrice.

Au niveau des contacts, la deuxième face de la couche conductrice est destinée à établir une connexion par contact électrique avec un lecteur de cartes à puce. La première face de la couche conductrice est destinée à établir, au niveau de puits de connexion, une connexion électrique avec une puce électronique.

Au niveau des plages conductrices, la première face de la couche conductrice obture au moins partiellement au moins un puits de connexion destiné à la connexion d'une puce électronique avec une antenne.

Avec ce circuit, on peut réaliser un module de carte à puce comportant donc des contacts conformes au standard de la carte à puce et des plages conductrices pour la connexion avec une antenne. Ce module comporte alors des premiers trous borgnes (puits de connexion au moins partiellement obturés par des contacts) pour la connexion de la puce aux contacts et des deuxièmes trous borgnes (puits de connexion au moins partiellement obturés par des plages conductrices) pour la connexion de la puce à l'antenne. La connexion de l'antenne (dans la carte) au module pouvant se faire soit par des troisièmes trous borgnes (puits de connexion au moins partiellement obturés par des plages conductrices) distincts des deuxièmes trous borgnes, soit par les mêmes deuxièmes trous borgnes que ceux servant à la connexion de la puce aux plages conductrices, soit directement à travers un substrat électriquement conducteur selon son épaisseur et électriquement isolant dans un plan perpendiculaire à cette épaisseur.

La fixation mécanique de la puce électronique sur le substrat est réalisée par au moins une technique connue telle que le fixage de puce (« die-attach » selon la terminologie anglo-saxonne) et sa connexion électrique aux contacts et à l'antenne est réalisée par au moins une technique connue telle que la technologie de la puce retournée (« flip-chip » selon la technologie anglo-saxonne), la soudure de fils (« wire-bonding » selon la terminologie anglo-saxonne), etc.

D'autres caractéristiques et avantages de l'invention apparaîtront à la lecture de la description détaillée et des dessins annexés sur lesquels :
- La figure 1 représente schématiquement en perspective une carte à puce destinée à recevoir un circuit pour carte à puce selon l'invention ;
- La figure 2 représente schématiquement vu par sa face avant, un circuit avec des contacts, ce circuit étant destiné à réaliser un module pour une carte telle que celle représentée sur la figure 1 ;
- La figure 3 représente de manière analogue à la figure 2, une variante du circuit de la figure 2 ;
- La figure 4 représente de manière analogue à la figure 2, une variante des circuits des figures 2 et 3 et son intégration dans une cavité de carte à puce ;
- les figures 5, 6, 7, 8(a, b, c), 9, 10, 11 et 12 représentent schématiquement en coupe différents exemples de mode de réalisation d'un circuit tel que celui des figures 2 à 4, avec ses connexions à une puce et à une antenne, les figures 8a et 8b illustrant des étapes permettant d'aboutir à la structure montrée à la figure 8c.

Dans ce texte, on appelle « zone conductrice 17» une zone (positionnée selon la norme ISO 7816-2 et aussi appelée dans ce texte « contact » 6) de la couche conductrice 16 qui peut être destinée à une connexion par contact entre la puce 8 et un lecteur de carte, ou bien une zone (aussi appelée plage conductrice 14) de la couche conductrice 16 qui peut être destinée à une connexion, conformément à l'invention, de la puce à une antenne. Les plages conductrices 14 correspondent donc à des zones conductrices 17, similaires aux contacts 6, mais qui ne sont pas connectées à une puce 8 pour une communication, par contact, avec un lecteur de carte. Elles peuvent donc être utilisées pour une connexion à une antenne.

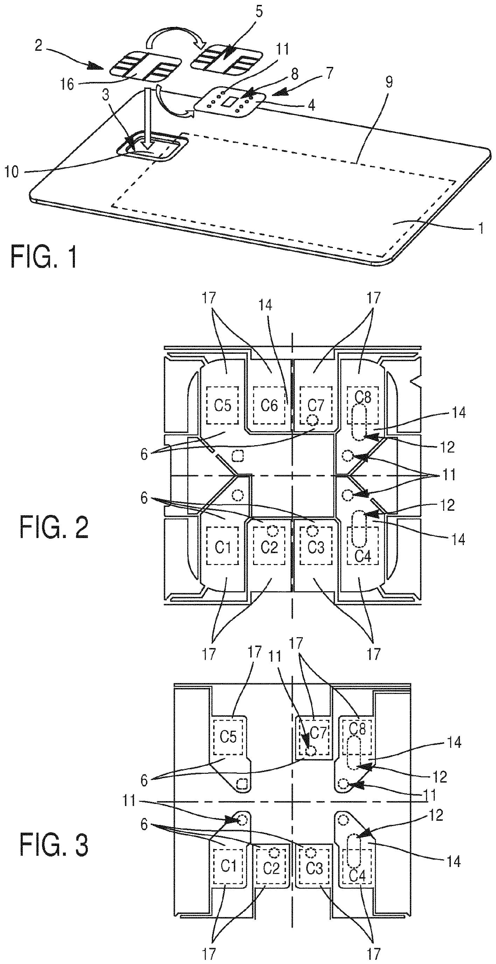

Comme représenté sur la figure 1, l'invention peut être utilisée pour la réalisation d'une carte à puce 1 (de type carte bancaire ou autre). Cette carte 1 comporte un module 2 destiné à être inséré dans une cavité 3, par exemple fraisée dans le corps de la carte 1. Ce module 2 comporte un substrat 4 électriquement isolant, avantageusement flexible. Sur l'une des faces de ce substrat 4, dite face avant 5, sont réalisés, dans une couche conductrice 16, des zones conductrices (c'est-à-dire des contacts et des plages conductrices) isolées électriquement les unes des autres.

Sur l'autre face dite face arrière 7, le substrat 4 supporte une puce 8. Le substrat 4 avec les contacts 6 et les plages conductrices constitue un circuit flexible métallisé.

La couche conductrice 16 est donc supportée par le substrat 4, avec une première face tournée vers le substrat 4 et une deuxième face destinée à établir une connexion par contact électrique avec un lecteur de cartes à puce (non-représenté).

Une antenne 9 (par exemple de taille Classe 1 ou Classe 2 selon la norme ISO 14443-1), est insérée dans le corps de la carte 1, entre deux couches laminées. Les extrémités 10 de cette antenne 9 sont accessibles dans la cavité 3, après fraisage de celle-ci, pour une connexion avec la puce 8.

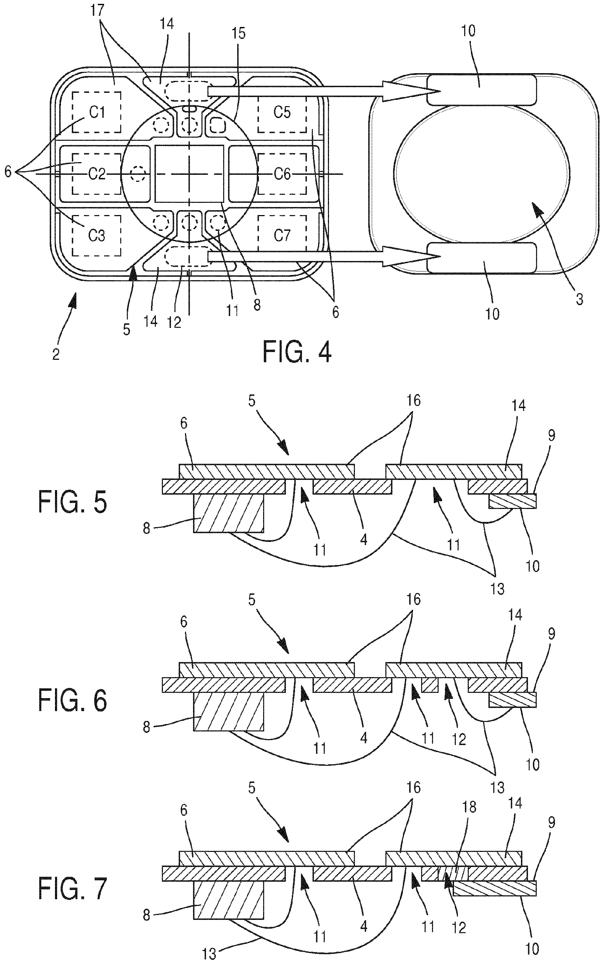

Les contacts sont connectés à la puce 8 avec des fils (non-visibles sur la figure 1, mais représentés sur les figures 5 à 11) à travers des puits de connexion 11 ménagés dans le substrat 4. Ces puits de connexion 11 sont par exemple réalisés par perforation du substrat 4, avant lamination de la couche conductrice 16 avec le substrat 4. La couche conductrice 16 recouvre au moins en partie les puits de connexion 11, la première face de la couche conductrice 16 formant donc le fond de ces puits de connexion. Les puits de connexion 11 forment alors des trous borgnes et permettent l'accès à la face avant 5, depuis la face arrière 7, avec une seule couche conductrice 16 sur la face avant 5.

La couche conductrice 16 peut recevoir sur sa première et/ou sa deuxième face(s) diverses couches de métallisation (Nickel, or, etc.). La qualité de la première face (généralement métallisée) de la couche conductrice 16 est importante pour assurer une bonne connexion à la puce, par exemple par soudure de fils conducteurs 13.

Comme représenté schématiquement sur la figure 2, les zones conductrices 17 (dont les dimensions et la position sont définies par la norme ISO 7816-2), sont par exemple au nombre de huit (C1, C2, C3, C4, C5, C6, C7 et C8). Les formes rectangulaires simples en traits pointillés autour des références C1 à C8 représentent les dimensions minimales et les emplacements des zones conductrices C1 à C8 selon la norme ISO 7816-2. Les zones conductrices C1, C2, C3, C5 et C7 sont toujours utilisées comme contacts pour une connexion entre la puce 8 et un dispositif lecteur de carte. En dehors des applications NFC, la zone conductrice C6 n'est pas utilisée et en dehors des applications USB, les zones conductrices C4 et C8 ne sont pas utilisées pour des applications de cartes bancaires à double-interface. Les plages conductrices 14 correspondant aux contacts C6, C4 et C8 ne sont pas, dans ces cas-là utilisées pour établir une connexion électrique entre la puce 8 et un lecteur de carte. Les plages conductrices C4 et C8, peuvent donc servir, selon l'invention, à la connexion de l'antenne 9. En effet, en réalisant des trous borgnes 12 (semblables aux puits de connexion 11, mais par exemple plus grands, oblongs, etc.) à travers le substrat 4, il est possible d'utiliser deux plages conductrices (dans cet exemple C4 et C8) pour connecter l'antenne 9 à la puce 8.

Différentes manières de réaliser cette connexion sont présentées plus loin en relation avec les figures 5 à 11.

Selon une variante, représentée sur la figure 3, les zones conductrices 17 sont au nombre de sept dont cinq contacts 6 à proprement parler et deux plages conductrices 14. La surface de la zone conductrice C5 est considérablement réduite, la zone conductrice C6 est supprimée, et plus globalement, les surfaces conductrices métallisées pour réaliser les contacts 6 et les plages conductrices 14 sont minimisées pour couvrir, d'une part, essentiellement les surfaces minimales requises par la norme ISO 7816-2 pour les zones conductrices C1, C2, C3, C4, C5, C7 et C8, et d'autre part, les puits de connexion 11 et trous borgnes 12. On peut remarquer que les puits de connexion 11 et les trous borgnes 12 occupent les mêmes positions que dans l'exemple précédent.

Selon encore une autre variante représentée sur la figure 4, les zones conductrices 17 sont au nombre de huit, dont cinq contacts 6 à proprement parler (C1, C2, C3, C5 et C7), deux plages conductrices 14 pour la connexion de l'antenne et la zone conductrice C6 qui reste inutilisée, sauf pour une fonction esthétique). En traits pointillés sont représentés les puits de connexion 11 et les trous oblongs 12, permettant la connexion (schématisée par les traits pleins entre les puits de connexion 11 et la puce 8) des contacts 6 et des plages conductrices 14 à la puce 8 (en face arrière) à travers le substrat, grâce à des fils de connexion 13. Le cercle correspondant à la zone d'encapsulation 15 de la puce 8 et de ses fils de connexions 13 laisse dégagés les trous oblongs 12 pour qu'ils puissent être ensuite connectés à une antenne 9. En effet, comme représenté à droite sur la figure 4, les extrémités 10 de l'antenne sont découvertes lors du fraisage de la cavité 3. Lors de l'insertion du module 2 dans la cavité 3, les plages conductrices 14 viennent en vis-à-vis des extrémités 10 (voir comme indiqué par les flèches) pour y être connectées.

Cette configuration est particulièrement avantageuse du point de vue de la miniaturisation, comme de l'orientation par rapport à l'antenne.

En effet, comme les deux plages conductrices 14 sont réalisées chacune respectivement essentiellement de part et d'autre d'une zone centrale destinée à recevoir la puce électronique 8, l'encombrement en largeur du module est limité essentiellement à celui de trois contacts 6 agencés et répartis sur une rangée. On a donc deux rangées de trois contacts 6, situées chacune respectivement de part et d'autre d'une zone centrale destinée à recevoir la puce électronique 8. Il reste deux zones entre ces deux rangées, de part et d'autre de cette zone centrale qui peuvent être utilisées pour former les plages conductrices 14. Ces plages conductrices 14 se trouvent en vis-à-vis des extrémités 10 de l'antenne, de part et d'autre de la cavité 3.

La connexion des plages conductrices à une antenne 9 peut être réalisée de nombreuses manières.

La figure 5, représente en coupe, un substrat 4 avec une couche conductrice 16 dans laquelle ont été réalisés des contacts 6 et des plages conductrices 14. Une puce 8 est fixée sur la face du substrat opposée à celle sur laquelle repose la couche conductrice 16. Des puits de connexion 11 permettent de connecter la puce 8 à la première face de la couche conductrice 16 grâce à des fils de connexion 13 de type or ou cuivre. Dans cet exemple de mode de réalisation, les extrémités 10 de l'antenne 9 sont également connectées à la première face de la couche conductrice 16 grâce à des fils de connexion 13. Dans ce cas, on connecte une extrémité 10 d'antenne et la puce 8, à une plage conductrice 14, à travers un même puits de connexion 11, éventuellement élargi par rapport à ceux nécessaires à la connexion de la puce 8 à un contact 6.

Selon la variante illustrée par la figure 6, on connecte une extrémité 10 d'antenne 9 et la puce 8, à une plage conductrice 14, à travers deux trous distincts (par exemple un puits de connexion 11 rond et un trou borgne 12 oblong) séparés par une portion de substrat 4.

Selon la variante illustrée par la figure 7, on remplace la connexion filaire de l'extrémité 10 de l'antenne 9 à la plage conductrice 14, par une pâte, une colle ou une encre conductrice chargée 18. La pâte conductrice est par exemple une pâte à souder comprenant un alliage métallique binaire ou ternaire tel que AgSn, AgSnBi ou AgSnCu. La colle et l'encre conductrice sont chargées de particules métalliques conductrices telles que l'argent ou le cuivre.

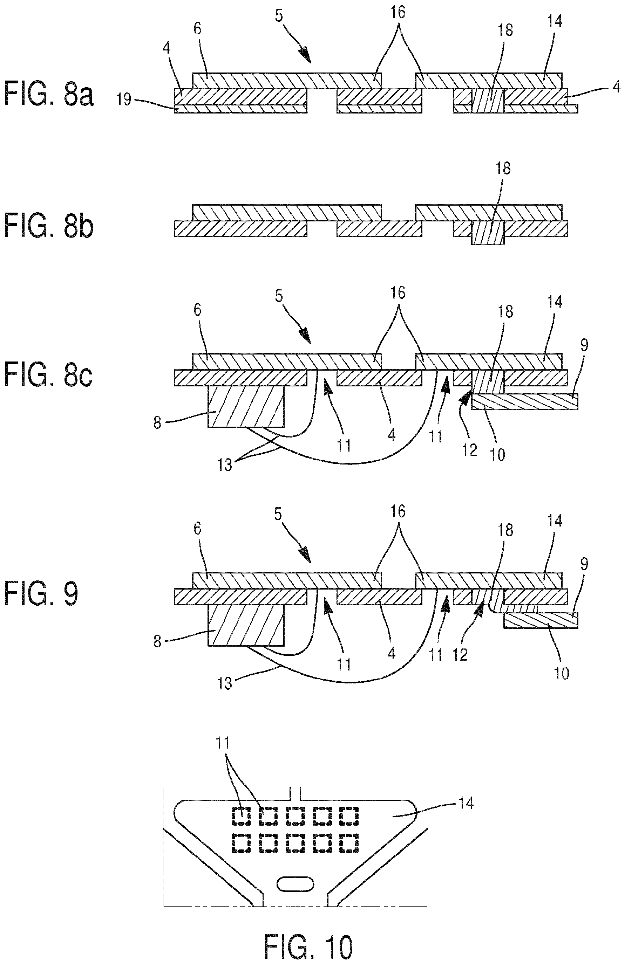

Selon la variante illustrée par les figures 8a à 8c, on utilise un film support protecteur 19 du substrat 4 (nécessaire en particulier dans le cas d'un substrat 4 adhésif réactivable à chaud) pour former une surépaisseur de pâte conductrice 18 (fig. 8a) comprise, par exemple, entre 50 et 100µm. On retire ensuite, par exemple juste avant encartage du module, le film protecteur 19, laissant ainsi la pâte conductrice 18 en surépaisseur (fig. 8b), pour faciliter la connexion avec une extrémité 10 d'antenne 9, lorsque le module est intégré dans la carte (fig. 8c). Les autres éléments du module demeurant par exemple essentiellement similaires à ceux des variantes présentées ci-dessus.

Selon la variante illustrée par la figure 9, on fait déborder la pâte conductrice 18 du trou borgne 12, sur la face arrière du substrat 4 de manière à former, là encore, une surépaisseur qui facilitera la connexion avec une extrémité 10 d'antenne 9, lors de l'intégration du module dans une carte.

La figure 10 représente schématiquement, vue de dessus, une plage conductrice 14 telle que celle du mode de réalisation illustré par la figure 4. La fixation et la connexion des extrémités de l'antenne aux plages conductrices 14, lorsqu'elles sont réalisées notamment comme dans les modes de réalisation illustrés sur les figures 7 à 9, peuvent être renforcées en utilisant plusieurs puits de connexion 11. Par exemple, les puits de connexion 11 forment une sorte de grille au travers de laquelle est dispensée la pâte, la colle ou l'encre conductrice 18.

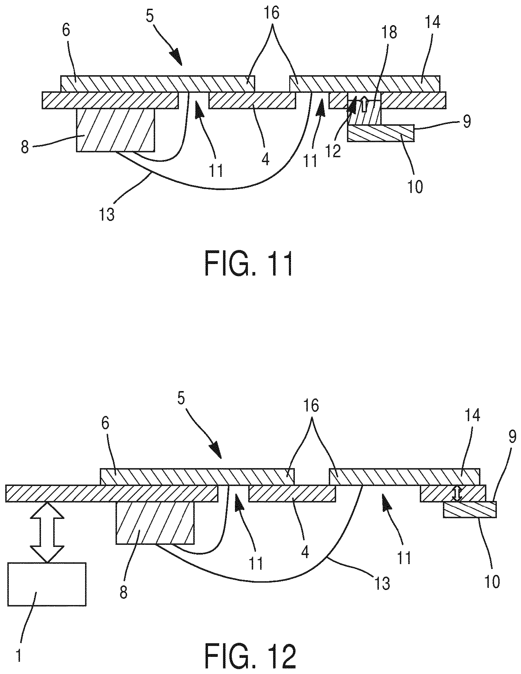

Alternativement, comme illustré sur la figure 11, on laisse un trou borgne 12 vide et sans résine d'encapsulation, pour qu'il puisse recevoir une extrémité 10 d'antenne 9 munie d'une surépaisseur de pâte conductrice 18, et en permettre la connexion avec la première face de la plage conductrice 14.

Selon la variante illustrée sur la figure 12, on utilise un substrat 4 adhésif thermo-réactivable ayant des propriétés conductrices anisotropes. Ce substrat 4 permet d'établir une connexion électrique directe (représentée par la flèche noire) entre une extrémité 10 d'antenne 9 et la première face de la plage conductrice 14, lors de l'opération d'encartage sous pression et à chaud.

Le fait d'utiliser un substrat 4 ayant des propriétés adhésives thermo-réactivables permet de coller directement la puce 8 sur le substrat 4, sans ajout de colle telle que celle habituellement utilisées pour le collage des puces (« die attach ») et le module 2 dans la carte 1 (voir flèche blanche). Avantageusement, le substrat 4 adhésif thermo-réactivable est choisi de manière à

- être disponible en bobines pour être compatible avec un procédé continu de bobine à bobine ;
- avoir une résistance thermique au moins jusqu'à 130° C ;
- avoir une résistance chimique aux solvants, aux bases et aux acides utilisés dans les procédés de gravure chimique du cuivre ;
- avoir une résistance chimique aux bains de métallisation électrolytique (nickel, or, argent, etc.) ;
- permettre un collage de la puce avec une force de cisaillement (en kgf) supérieure à 1,2 fois la surface de la puce (en mm²) ;
- permettre une soudure ultrasonique des fils conducteurs 13 qui connectent la puce 8 à la couche conductrice 1 avec une force supérieure ou égale à 3gf ; et
- permettre d'obtenir une force d'arrachement du module 2 après collage dans la carte 1 avec une force supérieure ou égale à 60N.

Les substrats 4 compatibles avec ces exigences correspondent par exemple aux références 844 ou 8410 de Tesa®, G185A de Scapa®, HiBond-3 de Cardel® ou bien FB-ML4 de Nitto®. Plus généralement, des substrats 4 basés sur une chimie co-polyamide, nitrile-phénolique, polyoléfine, polyester, polyuréthanes, EVA, époxy peuvent être compatibles avec l'invention.

Le substrat 4 adhésif thermo-réactivable peut être renforcé par des fibres textiles organiques (PET) ou minérales (verre) tissées ou non tissées afin d'améliorer ses propriétés mécaniques lors des étapes de défilement en continu. Par exemple, les tissus de verre référence 1080-Greige ou bien G106 de Porcher® peuvent être colaminés à chaud en continu pour réaliser un substrat 4 composite avec des propriétés mécaniques optimisées.

Une résine disponible sous forme de granulés, enduite à chaud sur des fibres textiles en utilisant par exemple la technologie d'injection par buse (« slot-die » selon la terminologie anglo-saxonne) peut être utilisée pour obtenir un substrat 4 adhésif thermo-réactivable.

Donc grâce à ce type de substrat 4, renforcé ou non, on peut coller la puce 8 directement dessus, alors que dans les procédés de l'art antérieur une colle devait être dispensée au cours d'une étape supplémentaire avant d'intégrer le module 2 dans la carte 1. Ceci est particulièrement avantageux notamment lorsque que les étapes de réalisation du module 2 d'une part, et d'intégration du module 2 dans une carte 1 d'autre part, sont réalisées par des opérateurs distincts.

La solution consistant à utiliser un substrat adhésif évite en outre d'avoir, d'une part, à procéder à l'enduction d'une couche de colle entre un substrat diélectrique de type verre époxy par exemple et la couche conductrice et, d'autre part, à la réticulation de cette colle après lamination de la couche conductrice sur le substrat.

En plus de ses propriétés adhésives thermo-réactivables, le substrat peut avoir, comme indiqué ci-dessus, des propriétés de conduction électrique anisotropes (« ACF » pour « Anisotropic Conductive Film » selon la terminologie anglo-saxonne). Des substrats ayant ce type de propriété correspondent par exemple aux références HAF 8412 et HAF 8414 de Tesa® constituées respectivement de masses phénolique et co-polyamide pour assurer la fonction adhésion, et chargées respectivement de micro-billes de verre et de cuivre recouvertes d'argent avec une densité par exemple de 60/mm² pour assurer la fonction conduction électrique selon la direction de l'épaisseur du substrat.

Les substrats aux propriétés de conduction électrique anisotropes pouvant être utilisés pour la réalisation de circuits selon l'invention peuvent être également renforcés mécaniquement comme indiqué ci-dessus.

Le fait de rapporter sur un élément unique (le substrat 4) deux fonctions (collage connexion électrique), permet une miniaturisation des modules pour carte à puce par rapport à des modules dans lesquels ces deux fonctions sont réalisées par des éléments différents.

## Revendications

1. Procédé de fabrication d'un circuit pour module (2) de carte à puce (1) comprenant
- la fourniture d'un substrat (4) isolant,
- la perforation du substrat (4) isolant pour former des puits de connexion (11),
- la fourniture d'une couche conductrice (16) supportée par le substrat (4) isolant, avec une première face tournée vers le substrat (4) isolant et une deuxième face,
- la réalisation, dans la couche conductrice (16), de contacts (6) au niveau desquels
o la deuxième face est destinée à établir une connexion par contact électrique avec un lecteur de cartes à puce, et
o la première face est destinée à établir, au niveau de puits de connexion (11), une connexion électrique avec une puce électronique (8),
dans lequel on réalise aussi dans la couche conductrice (16) au moins deux plages conductrices (14), électriquement isolées des contacts (6), au niveau desquelles la première face de la couche conductrice (16) obture au moins partiellement au moins un puits de connexion (11) destiné à la connexion de la puce électronique (8) avec une antenne (9),
**caractérisé par le fait que** l'on connecte la puce à une plage conductrice (14) de la première face de la couche conductrice (16) à travers un puits de connexion (11) et on connecte une extrémité (10) de l'antenne à travers ce même puits de connexion (11).

2. Procédé selon la revendication 1, dans lequel on connecte la puce à une plage conductrice (14) de la première face de la couche conductrice (16) à travers ledit même puits de connexion (11), à l'aide d'un fil de connexion (13).

3. Procédé selon la revendication 1 ou 2, dans lequel on réalise une partie d'un puits de connexion (11) avec la puce électronique (8) dans une zone d'encapsulation (15) correspondant à une zone destinée à être recouverte par un matériau de protection de la puce (5) et de ses connexions (13) aux contacts (6) et aux plages conductrices (14).

4. Procédé selon la revendication précédente, dans lequel, au cours d'une étape d'encapsulation, on encapsule la zone destinée à être recouverte par un matériau de protection de la puce (5) et de ses connexions (13) aux contacts (6) et aux plages conductrices (14) et la connexion de chaque plage conductrice (14) de la première face de la couche conductrice (16), avec l'extrémité (10) de l'antenne est réalisée après l'étape d'encapsulation.

5. Procédé selon l'une des revendications précédentes, dans lequel on dépose une pâte conductrice (18) en surépaisseur sur deux plages conductrices (14), électriquement isolées des contacts (6), au niveau desquelles la première face de la couche conductrice (16) obture au moins partiellement au moins un puits de connexion (11)) destiné à la connexion de la puce électronique (8) avec une antenne (9).

6. Procédé selon l'une des revendications précédentes, dans lequel on réalise sur un module (2), deux rangées de trois contacts (6), situées chacune respectivement de part et d'autre d'une zone centrale destinée à recevoir la puce électronique (8), et deux plages conductrices (14), de part et d'autre de cette zone centrale.

7. Procédé selon l'une des revendications précédentes, dans lequel l'encombrement en largeur du module (2) est limité essentiellement à celui de trois contacts (6) agencés et répartis sur une rangée.

8. Procédé selon l'une des revendications précédentes, dans lequel deux puits de connexion (11) de l'antenne (9) à une plage conductrice (14) sont situés chacun respectivement essentiellement de part et d'autre d'une zone d'encapsulation (15).

9. Procédé selon l'une des revendications précédentes, dans lequel on réalise des contacts (6) répartis sur deux rangées, les deux plages conductrices (14) et une zone centrale destinée à recevoir la puce électronique (8) étant réparties sur une rangée située entre les rangées de contacts.

10. Procédé selon l'une des revendications précédentes, dans lequel on réalise un puits de connexion (11) destiné à la connexion de la puce électronique (8) avec une antenne (9) au niveau de chacune des deux plages conductrices (14), la distance entre ces deux puits de connexion (11), situés chacun respectivement au niveau d'une plage conductrice, étant supérieure à la dimension d'une cavité ménagée dans la carte pour recevoir la puce électronique (8) et une résine d'encapsulation.

11. Procédé selon l'une des revendications précédentes, dans lequel on réalise cinq contacts (6) dans la couche conductrice (16), chacun respectivement pour la connexion de la masse, de l'alimentation, de l'entrée/sortie, de l'horloge et la remise à zéro d'une puce électronique (8), ainsi que deux plages conductrices (14) supplémentaires.

12. Procédé selon l'une des revendications précédentes, dans lequel on réalise un réseau de trous de connexion au niveau de chaque plage conductrice.

13. Procédé selon l'une des revendications précédentes, dans lequel les puits de connexion (11) au moins partiellement obturés par les plages conductrices (14) ont une forme allongée dans un plan parallèle aux première et deuxième faces de la couche conductrice (16).

14. Procédé de fabrication d'une carte à puce, dans lequel
- on fournit un corps de carte dans lequel est insérée l'antenne (9),
- on réalise une cavité (3) dans le corps de carte,
- on fournit un module (2) de carte à puce comportant un circuit électrique fabriqué selon l'une des revendications précédentes, dans lequel on connecte une extrémité (10) de l'antenne au module (2) à travers dudit même puits de connexion (11) lors de l'intégration du module (2) dans la cavité.

15. Procédé selon la revendication précédente, dans lequel l'extrémité (10) de l'antenne est connectée aux plages conductrices (14) à l'aide d'une encre, d'une pâte conductrice (18), d'un matériau adhésif anisotrope, ou une pâte à souder.

16. Circuit électrique flexible pour la mise en oeuvre d'un procédé de fabrication d'un module (2) de carte à puce (1), ce circuit comprenant :
- un substrat (4) isolant avec des puits de connexion (11),
- une couche conductrice (16) supportée par le substrat (4) isolant, avec une première face tournée vers le substrat (4) isolant et une deuxième face, avec des contacts (6) formés dans cette couche conductrice (16), contacts (6) au niveau desquels
o la deuxième face est destinée à établir une connexion par contact électrique avec un lecteur de cartes à puce, et
o la première face est destinée à établir, au niveau de puits de connexion (11), une connexion électrique avec une puce électronique (8),
dans lequel la couche conductrice (16) comporte également au moins deux plages conductrices (14), électriquement isolées des contacts (6), au niveau desquelles la première face de la couche conductrice (16) obture au moins partiellement au moins un puits de connexion (11) destiné à la connexion de la puce électronique (8) avec une antenne (9),
**caractérisé par le fait que** ledit au moins un puits de connexion (11) destiné à la connexion de la puce électronique (8) avec l'antenne (9) permet également la connexion de la puce électronique (8) à ladite plage conductrice (14) de la première face de la couche conductrice (16).

17. Circuit selon la revendication 16, comportant une pâte conductrice ou une pâte à souder (18) en surépaisseur sur deux plages conductrices (14), électriquement isolées des contacts (6), au niveau desquelles la première face de la couche conductrice (16) obture au moins partiellement au moins un puits de connexion (11, 12) destiné à la connexion de la puce électronique (8) avec une antenne (9).

18. Circuit selon l'une des revendications 16 et 17, comportant un puits de connexion (11) avec la puce électronique (8) en partie dans une zone d'encapsulation (15) correspondant à une zone destinée à être recouverte par un matériau de protection de la puce (5) et de ses connexions (13) aux contacts (6) et aux plages conductrices (14).

19. Circuit selon l'une des revendications 16 à 18, comportant deux rangées de trois contacts (6), situées chacune respectivement de part et d'autre d'une zone centrale destinée à recevoir la puce électronique (8), et deux plages conductrices (14), de part et d'autre de cette zone centrale.

20. Circuit selon l'une des revendications 16 à 19, dans lequel l'encombrement en largeur du module (2) est limité essentiellement à celui de trois contacts (6) agencés et répartis sur une rangée.

21. Circuit selon l'une des revendications 16 à 20, comportant deux puits de connexion (11) de l'antenne (9) à une plage conductrice (14), sont situés chacun respectivement essentiellement de part et d'autre d'une zone d'encapsulation (15).

22. Circuit selon la revendication 21, comportant des puits de connexion (11) au moins partiellement obturés chacun par une plage conductrice (14) et dont la forme est allongée dans un plan parallèle aux première et deuxième faces de la couche conductrice.

23. Circuit selon l'une des revendications 16 à 22, comportant un puits de connexion (11) destiné à la connexion de la puce électronique (8) avec une antenne (9) au niveau de chacune des deux plages conductrices (14), la distance entre ces deux puits de connexion (11), situés chacun respectivement au niveau d'une plage conductrice, étant supérieure à la dimension d'une cavité ménagée dans la carte pour recevoir la puce électronique (8) et une résine d'encapsulation.

24. Circuit selon l'une des revendications 16 à 23, comprenant cinq contacts (6) dans la couche conductrice (16), chacun respectivement pour la connexion de la masse, de l'alimentation, de l'entrée/sortie, de l'horloge et la remise à zéro d'une puce électronique, ainsi que deux plages conductrices (14) supplémentaires pour la connexion d'une antenne (9).

## Patentansprüche

1. Verfahren zur Herstellung einer Schaltung für ein Modul (2) einer Chipkarte (1), umfassend:
- die Bereitstellung eines Isoliersubstrats (4),
- die Perforation des Isoliersubstrats (4), um Anschlussbuchsen (11) zu bilden,
- die Bereitstellung einer leitenden Schicht (16), die von dem Isoliersubstrat (4) getragen wird, mit einer ersten Seite, die zum Isoliersubstrat (4) gewandt ist, und einer zweiten Seite,
- in der leitenden Schicht (16) die Herstellung von Kontakten (6), in deren Bereich
o die zweite Seite dazu bestimmt ist, einen Anschluss durch elektrischen Kontakt mit einem Chipkartenleser herzustellen, und
o die erste Seite dazu bestimmt ist, im Bereich von Anschlussbuchsen (11) einen elektrischen Anschluss mit einem elektronischen Chip (8) herzustellen,
wobei auch in der leitenden Schicht (16) mindestens zwei leitende Bereiche (14) hergestellt werden, die elektrisch von den Kontakten (6) isoliert sind, in deren Bereich die erste Seite der leitenden Schicht (16) zumindest teilweise mindestens eine Anschlussbuchse (11) verschließt, die für den Anschluss des elektronischen Chips (8) an eine Antenne (9) bestimmt ist,
**dadurch gekennzeichnet, dass** der Chip an einen leitenden Bereich (14) der ersten Seite der leitenden Schicht (16) durch eine Anschlussbuchse (11) angeschlossen wird und ein Ende (10) der Antenne durch diese selbe Anschlussbuchse (11) angeschlossen wird.

2. Verfahren nach Anspruch 1, wobei der Chip mithilfe eines Anschlussdrahts (13) an einen leitenden Bereich (14) der ersten Seite der leitenden Schicht (16) durch dieselbe Anschlussbuchse (11) angeschlossen wird.

3. Verfahren nach Anspruch 1 oder 2, wobei ein Abschnitt einer Anschlussbuchse (11) mit dem elektronischen Chip (8) in einer Verkapselungszone (15), die einer Zone entspricht, die dazu bestimmt ist, mit einem Schutzmaterial des Chips (5) und seiner Anschlüsse (13) an die Kontakte (6) und an die leitenden Bereiche (14) beschichtet zu sein, hergestellt wird.

4. Verfahren nach dem vorhergehenden Anspruch, wobei bei einem Schritt des Verkapselns die Zone, die dazu bestimmt ist, mit einem Schutzmaterial des Chips (5) und seiner Anschlüsse (13) an die Kontakte (6) und an die leitenden Bereiche (14) beschichtet zu sein, verkapselt wird und der Anschluss jedes leitenden Bereichs (14) der ersten Seite der leitenden Schicht (16) an das Ende (10) der Antenne nach dem Schritt des Verkapselns erfolgt.

5. Verfahren nach einem der vorhergehenden Ansprüche, wobei eine Leitpaste (18) in Überdicke auf zwei leitende Bereiche (14) aufgetragen wird, die elektrisch von den Kontakten (6) isoliert sind, in deren Bereich die erste Seite der leitenden Schicht (16) zumindest teilweise mindestens eine Anschlussbuchse (11) verschließt, die für den Anschluss des elektronischen Chips (8) an eine Antenne (9) bestimmt ist.

6. Verfahren nach einem der vorhergehenden Ansprüche, wobei an einem Modul (2) zwei Reihen von drei Kontakten (6), die sich jeweils beiderseits einer zentralen Zone befinden, die dazu bestimmt ist, den elektronischen Chip (8) aufzunehmen, und zwei leitende Bereiche (14) beiderseits dieser zentralen Zone hergestellt werden.

7. Verfahren nach einem der vorhergehenden Ansprüche, wobei der Platzbedarf in der Breite des Moduls (2) im Wesentlichen auf jenen von drei Kontakten (6), die auf einer Reihe angeordnet und verteilt sind, begrenzt ist.

8. Verfahren nach einem der vorhergehenden Ansprüche, wobei sich zwei Anschlussbuchsen (11) der Antenne (9) an einen leitenden Bereich (14) jeweils im Wesentlichen beiderseits einer Verkapselungszone (15) befinden.

9. Verfahren nach einem der vorhergehenden Ansprüche, wobei auf zwei Reihen verteilte Kontakte (6) hergestellt werden, wobei die zwei leitenden Bereiche (14) und eine zentrale Zone, die dazu bestimmt ist, den elektronischen Chip (8) aufzunehmen, auf einer Reihe verteilt sind, die sich zwischen den Kontaktreihen befindet.

10. Verfahren nach einem der vorhergehenden Ansprüche, wobei eine Anschlussbuchse (11) hergestellt wird, die für den Anschluss des elektronischen Chips (8) an eine Antenne (9) im Bereich jedes der zwei leitenden Bereiche (14) bestimmt ist, wobei der Abstand zwischen diesen zwei Anschlussbuchsen (11), die sich jeweils im Bereich eines leitenden Bereichs befinden, größer als die Dimension eines Hohlraums ist, der in der Karte ausgespart ist, um den elektronischen Chip (8) und ein Verkapselungsharz aufzunehmen.

11. Verfahren nach einem der vorhergehenden Ansprüche, wobei fünf Kontakte (6) in der leitenden Schicht (16) jeweils für den Anschluss der Masse, der Versorgung, des Eingangs/Ausgangs, der Uhr bzw. der Rücksetzung eines elektronischen Chips (8), sowie zwei zusätzliche leitende Bereiche (14) hergestellt werden.

12. Verfahren nach einem der vorhergehenden Ansprüche, wobei ein Netz von Anschlusslöchern auf Höhe jedes leitenden Bereichs hergestellt wird.

13. Verfahren nach einem der vorhergehenden Ansprüche, wobei die Anschlussbuchsen (11), die zumindest teilweise durch die leitenden Bereiche (14) verschlossen sind, eine längliche Form in einer Ebene parallel zu der ersten und zweiten Seite der leitenden Schicht (16) aufweisen.

14. Verfahren zur Fertigung einer Chipkarte, wobei
- ein Kartenkörper bereitgestellt wird, in den die Antenne (9) eingesetzt wird,
- ein Hohlraum (3) im Kartenkörper ausgespart wird,
- ein Modul (2) einer Chipkarte bereitstellt wird, das eine elektrische Schaltung aufweist, die nach einem der vorhergehenden Ansprüche gefertigt ist, wobei ein Ende (10) der Antenne bei der Integration des Moduls (2) in den Hohlraum durch dieselbe Anschlussbuchse (11) an das Modul (2) angeschlossen wird.

15. Verfahren nach dem vorhergehenden Anspruch, wobei das Ende (10) der Antenne mithilfe einer Tinte, einer Leitpaste (18), eines anisotropen haftenden Materials oder einer Lötpaste an die leitenden Bereiche (14) angeschlossen wird.

16. Flexible elektrische Schaltung für den Einsatz eines Verfahrens zur Herstellung eines Moduls (2) einer Chipkarte (1), wobei diese Schaltung Folgendes umfasst:
- ein Isoliersubstrat (4) mit Anschlussbuchsen (11),
- eine leitende Schicht (16), die von dem Isoliersubstrat (4) getragen wird, mit einer ersten Seite, die zum Isoliersubstrat (4) gewandt ist, und einer zweiten Seite mit Kontakten (6), die in dieser leitenden Schicht (16) ausgebildet sind, wobei im Bereich dieser Kontakte (6)
o die zweite Seite dazu bestimmt ist, einen Anschluss durch elektrischen Kontakt mit einem Chipkartenleser herzustellen, und
o die erste Seite dazu bestimmt ist, im Bereich von Anschlussbuchsen (11) einen elektrischen Anschluss mit einem elektronischen Chip (8) herzustellen,
wobei die leitende Schicht (16) auch mindestens zwei leitende Bereiche (14) umfasst, die elektrisch von den Kontakten (6) isoliert sind, in deren Bereich die erste Seite der leitenden Schicht (16) zumindest teilweise mindestens eine Anschlussbuchse (11) verschließt, die für den Anschluss des elektronischen Chips (8) an eine Antenne (9) bestimmt ist,
**dadurch gekennzeichnet, dass** die mindestens eine Anschlussbuchse (11), die für den Anschluss des elektronischen Chips (8) an die Antenne (9) bestimmt ist, ebenfalls den Anschluss des elektronischen Chips (8) an den leitenden Bereich (14) der ersten Seite der leitenden Schicht (16) gestattet.

17. Schaltung nach Anspruch 16, umfassend eine Leitpaste oder eine Lötpaste (18) in Überdicke auf zwei leitenden Bereichen (14), die elektrisch von den Kontakten (6) isoliert sind, in deren Bereich die erste Seite der leitenden Schicht (16) zumindest teilweise mindestens eine Anschlussbuchse (11, 12) verschließt, die für den Anschluss des elektronischen Chips (8) an eine Antenne (9) bestimmt ist.

18. Schaltung nach einem der Ansprüche 16 und 17, umfassend eine Anschlussbuchse (11) mit dem elektronischen Chip (8) teilweise in einer Verkapselungszone (15), die einer Zone entspricht, die dazu bestimmt ist, mit einem Schutzmaterial des Chips (5) und seiner Anschlüsse (13) an die Kontakte (6) und an die leitenden Bereiche (14) beschichtet zu sein.

19. Schaltung nach einem der Ansprüche 16 bis 18, umfassend zwei Reihen von drei Kontakten (6), die sich jeweils beiderseits einer zentralen Zone befinden, die dazu bestimmt ist, den elektronischen Chip (8) aufzunehmen, und zwei leitende Bereiche (14) beiderseits dieser zentralen Zone.

20. Schaltung nach einem der Ansprüche 16 bis 19, wobei der Platzbedarf in der Breite des Moduls (2) im Wesentlichen auf jenen von drei Kontakten (6), die auf einer Reihe angeordnet und verteilt sind, begrenzt ist.

21. Schaltung nach einem der Ansprüche 16 bis 20, umfassend zwei Anschlussbuchsen (11) der Antenne (9) an einen leitenden Bereich (14), die sich jeweils im Wesentlichen beiderseits einer Verkapselungszone (15) befinden.

22. Schaltung nach Anspruch 21, umfassend Anschlussbuchsen (11), die zumindest teilweise jeweils durch einen leitenden Bereich (14) verschlossen sind, und deren Form in einer Ebene parallel zu der ersten und zweiten Seite der leitenden Schicht länglich ist.

23. Schaltung nach einem der Ansprüche 16 bis 22, umfassend eine Anschlussbuchse (11), die für den Anschluss des elektronischen Chips (8) an eine Antenne (9) im Bereich jedes der zwei leitenden Bereiche (14) bestimmt ist, wobei der Abstand zwischen diesen zwei Anschlussbuchsen (11), die sich jeweils im Bereich eines leitenden Bereichs befinden, größer als die Dimension eines Hohlraums ist, der in der Karte ausgespart ist, um den elektronischen Chip (8) und ein Verkapselungsharz aufzunehmen.

24. Schaltung nach einem der Ansprüche 16 bis 23, umfassend fünf Kontakte (6) in der leitenden Schicht (16), jeweils für den Anschluss der Masse, der Versorgung, des Eingangs/Ausgangs, der Uhr bzw. der Rücksetzung eines elektronischen Chips, sowie zwei zusätzliche leitende Bereiche (14) für den Anschluss einer Antenne (9).

## Claims

1. Method for producing a circuit for a chip card (1) module (2) comprising
- the provision of an insulating substrate (4),
- the perforation of the insulating substrate (4) in order to form connection wells (11),
- the provision of a conductive layer (16) supported by the insulating substrate (4), with a first side turned toward the insulating substrate (4) and a second side,
- the production, in the conductive layer (16), of contacts (6) at the level of which
o the second side is intended to establish a connection by electrical contact with a chip card reader, and
o the first side is intended to establish, at the level of connection wells (11), an electrical connection with an electronic chip (8),
in which at least two conductive lands (14), that are electrically isolated from the contacts (6), are also made in the conductive layer (16), at the level of which lands the first side of the conductive layer (16) at least partially closes up at least one connection well (11) that is intended to connect the electronic chip (8) to an antenna (9),
**characterized by** the fact that the chip is connected to a conductive land (14) of the first side of the conductive layer (16) through a connection well (11) and an end (10) of the antenna is connected through this same connection well (11).

2. Method according to Claim 1, in which the chip is connected to a conductive land (14) of the first side of the conductive layer (16) through said same connection well (11), using a connection wire (13).

3. Method according to Claim 1 or 2, in which part of a well (11) for connection with the electronic chip (8) is made in an encapsulation area (15) corresponding to an area intended to be covered with a material for protecting the chip (5) and its connections (13) to the contacts (6) and to the conductive lands (14).

4. Method according to the preceding claim, in which, in an encapsulation step, the area intended to be covered with a material for protecting the chip (5) and its connections (13) to the contacts (6) and to the conductive lands (14) is encapsulated and the connection of each conductive land (14) of the first side of the conductive layer (16) to the end (10) of the antenna is made after the encapsulation step.

5. Method according to one of the preceding claims, in which a conductive paste (18) is deposited with extra thickness on two conductive lands (14), that are electrically isolated from the contacts (6), at the level of which lands the first side of the conductive layer (16) at least partially closes up at least one connection well (11) that is intended to connect the electronic chip (8) to an antenna (9).

6. Method according to one of the preceding claims, in which two rows of three contacts (6) are made on a module (2), each row respectively being located on either side of a central area that is intended to accommodate the electronic chip (8), and two conductive lands (14), on either side of this central area.

7. Method according to one of the preceding claims, in which the bulk of the module (2) in terms of width is essentially limited to that of three contacts (6) arranged and distributed in a row.

8. Method according to one of the preceding claims, in which two wells (11) for connecting the antenna (9) to a conductive land (14) are each respectively essentially located on either side of an encapsulation area (15).

9. Method according to one of the preceding claims, in which contacts (6) distributed in two rows are made, the two conductive lands (14) and a central area that is intended to accommodate the electronic chip (8) being distributed in a row that is located between the rows of contacts.

10. Method according to one of the preceding claims, in which a connection well (11) that is intended for the connection of the electronic chip (8) to an antenna (9) is made at the level of each of the two conductive lands (14), the distance between these two connection wells (11), each being respectively located at the level of a conductive land, being greater than the size of a cavity made in the card in order to accommodate the electronic chip (8) and an encapsulation resin.

11. Method according to one of the preceding claims, in which five contacts (6) are made in the conductive layer (16), each respectively for connecting the ground, the power supply, the input/output, the clock and the reset of an electronic chip (8), as well as two additional conductive lands (14).

12. Method according to one of the preceding claims, in which an array of connection holes is made at the level of each conductive land.

13. Method according to one of the preceding claims, in which the connection wells (11) that are at least partially closed up by the conductive lands (14) have a form that is elongated along a plane parallel to the first and second sides of the conductive layer (16).

14. Method for producing a chip card, in which
- a card body is provided into which the antenna (9) is inserted,
- a cavity (3) is made in the card body,
- a chip card module (2) is provided comprising an electrical circuit produced according to one of the preceding claims, in which an end (10) of the antenna is connected to the module (2) through said same connection well (11) during the integration of the module (2) into the cavity.

15. Method according to the preceding claim, in which the end (10) of the antenna is connected to the conductive lands (14) using an ink, a conductive paste (18), an anisotropic adhesive material, or a solder paste.

16. Flexible electrical circuit for implementing a method for producing a chip card (1) module (2), this circuit comprising:
- an insulating substrate (4) with connection wells (11),
- a conductive layer (16) supported by the insulating substrate (4), with a first side turned toward the insulating substrate (4) and a second side, with contacts (6) that are formed in this conductive layer (16), at the level of which contacts (6)
o the second side is intended to establish a connection by electrical contact with a chip card reader, and
o the first side is intended to establish, at the level of connection wells (11), an electrical connection with an electronic chip (8),
in which the conductive layer (16) also comprises at least two conductive lands (14), that are electrically isolated from the contacts (6), at the level of which lands the first side of the conductive layer (16) at least partially closes up at least one connection well (11) that is intended to connect the electronic chip (8) to an antenna (9),
**characterized by** the fact that said at least one connection well (11) that is intended to connect the electronic chip (8) to the antenna (9) also allows the electronic chip (8) to be connected to said conductive land (14) of the first side of the conductive layer (16).

17. Circuit according to Claim 16, comprising a conductive paste or a solder paste (18) with extra thickness on two conductive lands (14), that are electrically isolated from the contacts (6), at the level of which lands the first side of the conductive layer (16) at least partially closes up at least one connection well (11, 12) that is intended to connect the electronic chip (8) to an antenna (9).

18. Circuit according to either of Claims 16 and 17, comprising a well (11) for connection with the electronic chip (8) partly in an encapsulation area (15) corresponding to an area intended to be covered with a material for protecting the chip (5) and its connections (13) to the contacts (6) and to the conductive lands (14).

19. Circuit according to one of Claims 16 to 18, comprising two rows of three contacts (6), each row respectively being located on either side of a central area that is intended to accommodate the electronic chip (8), and two conductive lands (14), on either side of this central area.

20. Circuit according to one of Claims 16 to 19, in which the bulk of the module (2) in terms of width is essentially limited to that of three contacts (6) arranged and distributed in a row.

21. Circuit according to one of Claims 16 to 20, comprising two wells (11) for connecting the antenna (9) to a conductive land (14), each respectively essentially located on either side of an encapsulation area (15).

22. Circuit according to Claim 21, comprising connection wells (11) that are each at least partially closed up by a conductive land (14) and whose form is elongated along a plane parallel to the first and second sides of the conductive layer.

23. Circuit according to one of Claims 16 to 22, comprising a connection well (11) that is intended for the connection of the electronic chip (8) to an antenna (9) at the level of each of the two conductive lands (14), the distance between these two connection wells (11), each being respectively located at the level of a conductive land, being greater than the size of a cavity made in the card in order to accommodate the electronic chip (8) and an encapsulation resin.

24. Circuit according to one of Claims 16 to 23, comprising five contacts (6) in the conductive layer (16), each respectively for connecting the ground, the power supply, the input/output, the clock and the reset of an electronic chip, as well as two additional conductive lands (14) for connecting an antenna (9).
